# EUROPEAN PATENT APPLICATION

(11) **EP 4 814 579 A1**
(43) Date of publication of application: **30.09.2026**
(21) Application number: 24912486.8
(22) Date of filing: 16.12.2024
(51) Int. Cl.: G03F 1/66, G03F 1/62, G03F 1/84

(54) **PELLICLE CASE, PELLICLE HOUSING BODY, AND PELLICLE INSPECTION METHOD**

(30) Priority: 25.12.2023 JP 2023218337
(71) Applicant: Mitsui Chemicals, Inc., Tokyo 104-0028 (JP)
(72) Inventor: TANAKA, Hirofumi, Tokyo 104-0028 (JP); ONO, Yosuke, Tokyo 104-0028 (JP)
(74) Representative: Hoffmann Eitle
(86) International application number: PCT/JP2024/044437
(87) International publication number: WO 2025/142597

(57) **Abstract**

The pellicle case according to the present disclosure is used for housing a pellicle including a pellicle film in a sealed state. The pellicle case includes a body and a lid. The body has a first planar window. The lid has a second planar window disposed opposite to the first planar window. The pellicle satisfies at least one of the following requirement (a) or (b).
(a) A light shielding layer is formed on at least a portion of the outer surface of one of the first planar window or the second planar window, a planar window on a side on which the light shielding layer is not formed has a transmittance for light having a wavelength of from 0.4 µm to 0.7 µm of 75% or more, and the light shielding layer has a reflectance for light having a wavelength of from 0.4 µm to 0.6 µm of 5% or less.
(b) The first planar window and the second planar window have a transmittance for light having a wavelength of from 2 µm to 10 µm of 70% or more.

## Description

### Technical Field

The present disclosure relates to a pellicle case, a pellicle assembly, and a pellicle inspection method.

### Background Art

The production process of a semiconductor device includes a lithography step of irradiating light onto a semiconductor wafer to form a pattern. In the lithography step, for example, light (also referred to as "exposure light") is irradiated to a pattern formed on a rectangular photomask substrate, and the exposure light transmitted through or reflected from the photomask substrate is projected on the wafer to form an image, thereby exposing a resist. In this manner, a predetermined pattern is transferred on the wafer.

In the lithography step, a pellicle is used for preventing the adhesion of foreign substances to the pattern formed on the photomask substrate. The pellicle is attached to the photomask substrate, and surrounds the pattern formed on the photomask substrate. The pellicle usually includes a pellicle frame and a pellicle film. The pellicle frame is arranged so as to surround the exterior of a pattern region formed on the photomask substrate. The pellicle film is provided so as to stretch over the pellicle frame.

In recent years, a pellicle including a carbon nanotube film (hereinafter, also referred to as "CNT film") as the pellicle film has been studied. The CNT film easily adsorbs gas in the surrounding environment (such as the atmosphere). It is becoming clear that the properties (such as EUV light transmittance) of the CNT film change from the properties of the CNT film immediately after the production, when gas is adsorbed onto the CNT film. When the properties of the CNT film change drastically from the properties of the CNT film immediately after the production, there is a risk that the CNT film may affect the pattern to be formed on the semiconductor wafer.

Patent Document 1 discloses a case (hereinafter, also referred to as "pellicle case") for housing a pellicle. This pellicle case includes a tray, and a lid that covers the tray. The pellicle case has a sealed structure. The sealed structure seals the gap between the peripheral portion of the lid and the tray, in a state where the lid covering the tray is sagged under its own weight. Engineering plastics, reinforced plastics and metals are disclosed as the materials of the lid and the tray.

Non-Patent Document 1 discloses that it is possible to reduce changes over time in the transmittance of the CNT film, by heating the CNT film to a temperature of more than 2,000°C.
Patent Document 1: Japanese Patent Application Laid-Open (JP-A) No. 2011-79545
Non-Patent Document 1: Mark van de Kerkhofa, et al., "EUV pellicle scanner integration for N2 nodes and beyond", Vol. 12494, Proc. of SPIE, 2023, 124940D-1 to 124940D-9

### SUMMARY OF INVENTION

### Technical Problem

A pellicle is usually shipped in a state housed in a pellicle case, and retrieved from the pellicle case before use. There is a case in which the state of the CNT film needs to be confirmed before using the pellicle.

For example, it is possible to inspect whether or not any defects are present in the CNTs included in the CNT film, by measuring the ratio of the intensity of the G band to the intensity of the D band (hereinafter, also referred to as "G/D ratio") of the CNT film, by Raman spectroscopy. In the present disclosure, the expression "intensity of the D band" refers to the peak intensity of the D band (in the vicinity of 1360 cm⁻¹) derived from defects in the graphite structure (SP2 bonding). The expression "intensity of the G band" refers to the peak intensity of the G band (in the vicinity of 1580 cm⁻¹) derived from the graphite structure (SP2 bonding). A higher G/D ratio indicates a higher crystallinity of the CNTs included in the CNT film. In other words, a higher G/D ratio indicates that fewer defects are present in the CNTs included in the CNT film.

It is possible to inspect whether or not any gas is adsorbed onto the CNT film, by measuring the emissivity of the CNT film by Fourier-transform infrared spectroscopy (hereinafter, also referred to as "FTIR method"). In general, the reflectance ρ, the transmittance τ and the absorption rate α, of an energy incident on an object, have a specific relationship (namely, reflectance ρ + transmittance τ + absorption rate α = 1). In the present disclosure, the "emissivity" at a certain wavelength indicates the absorption rate α obtained by subtracting the transmittance τ and the reflectance ρ at the certain wavelength, from the energy incident on an object in thermal equilibrium. For example, a spectral emissivity measurement device ("JIR-E500" manufactured by JEOL Ltd.) is used for measuring the emissivity. The emissivity of the CNT film onto which no gas is adsorbed is different from the emissivity of the CNT film onto which gas is adsorbed. Therefore, whether or not any gas is adsorbed onto the CNT film can be inspected, by comparing the measured value of the emissivity of the CNT film, with the measured value of the emissivity of the CNT film onto which no gas is adsorbed.

In the case of using the pellicle case disclosed in Patent Document 1, however, it is necessary to retrieve the pellicle from the pellicle case in order to confirm the state of the CNT film. As described above, the CNT film easily adsorbs gas in the surrounding environment. Consequently, there is a risk that the state of the CNT film cannot be accurately inspected. Therefore, there is a demand for a pellicle case that allows for the inspection of the pellicle film housed therein in a vacuum sealed state.

The present disclosure has been made in view of the above-described circumstances.

An object of one embodiment of the present disclosure is to provide a pellicle case and a pellicle assembly that allow for the inspection of the pellicle film housed therein in a sealed state.

An object of another embodiment of the present disclosure is to provide a pellicle inspection method capable of easily inspecting the pellicle film housed in the pellicle case in a vacuum sealed state.

### Solution to Problem

The means for solving the above-described problem include the following embodiments.
<1> A pellicle case for housing a pellicle including a pellicle film in a sealed state,
   the pellicle case including a body and a lid,
   in which the body has a first planar window for inspecting the pellicle film,
   in which the lid has a second planar window for inspecting the pellicle film, which is disposed opposite to the first planar window, and
   in which the pellicle case satisfies at least one of the following requirement (a) or (b):
      (a) a light shielding layer is formed on at least a portion of an outer surface of one of the first planar window or the second planar window,
         in which a planar window, among the first planar window and the second planar window, on a side on which the light shielding layer is not formed has a transmittance for light having a wavelength of from 0.4 µm to 0.7 µm of 75% or more, and
         in which the light shielding layer has a reflectance for light having a wavelength of from 0.4 µm to 0.6 µm of 5% or less; or
      (b) each of the first planar window and the second planar window has a transmittance for light having a wavelength of from 2 µm to 10 µm of 70% or more.
<2> The pellicle case according to <1>,
   in which the pellicle case satisfies the requirement (a), and
   in which the light shielding layer is formed on an entire outer surface of one of the first planar window or the second planar window.
<3> The pellicle case according to <1>, in which the pellicle case satisfies the requirement (b).
<4> The pellicle case according to <1>,
   in which the pellicle case satisfies the requirement (a), and
   in which the light shielding layer is formed on a portion of the outer surface of one of the first planar window or the second planar window.
<5> The pellicle case according to <4>, in which the pellicle case further satisfies the requirement (b).
<6> The pellicle case according to any one of <1> to <5>,
   in which at least one of the body or the lid has:
      a vent passage that communicates an interior and an exterior of the pellicle case;
      a valve capable of opening and closing the vent passage; and
      a filter disposed in the vent passage,
   in which the filter is located at a position closer to an interior side of the pellicle case than the valve.
<7> A pellicle assembly including:
   the pellicle case according to any one of <1> to <6>; and
   a pellicle housed in the pellicle case in a sealed state,
   in which the pellicle includes a pellicle film, and
   in which the first planar window is disposed opposite to the second planar window with the pellicle film interposed therebetween.
<8> A method of inspecting the pellicle housed in the pellicle assembly according to <7> in a sealed state,
   in which the pellicle case satisfies the requirement (a), and
   in which the pellicle film includes a plurality of carbon nanotubes,
   the method including irradiating excitation light to the pellicle film through another one of the first planar window or the second planar window, to measure a ratio of an intensity of G band to an intensity of D band, by Raman spectroscopy.
<9> A method of inspecting the pellicle housed in the pellicle assembly according to <7> in a vacuum sealed state,
   in which the pellicle case satisfies the requirement (b),
   the method including irradiating continuous light to the pellicle film through one of the first planar window or the second planar window, to measure an emissivity by Fourier-transform infrared spectroscopy.

### Advantageous Effects of Invention

According to one embodiment of the present disclosure, it is possible to provide a pellicle case and a pellicle assembly that allow for the inspection of the pellicle film housed therein in a sealed state.

According to another embodiment of the present disclosure, it is possible to provide a pellicle inspection method capable of easily inspecting the pellicle film housed in the pellicle case in a sealed state.

### BRIEF DESCRIPTION OF DRAWINGS

FIG. 1 is a perspective view showing the appearance of a pellicle assembly according to a first embodiment of the present disclosure.
FIG. 2 is a cross-sectional view taken along the line II-II shown in FIG. 1.
FIG. 3 is a cross-sectional view showing a pellicle assembly according to a second embodiment of the present disclosure.
FIG. 4 is a cross-sectional view showing a pellicle assembly according to a third embodiment of the present disclosure.

### DESCRIPTION OF EMBODIMENTS

In the present disclosure, a numerical range indicated using the expression "to" refers to a range that includes numerical values described before and after the preposition "to" as a minimum value and a maximum value, respectively.

In numerical ranges described stepwise, in the present disclosure, an upper limit value or a lower limit value described in a certain numerical range may be replaced with an upper limit value or a lower limit value in another numerical range described stepwise. In a numerical range described in the present disclosure, the upper limit value or the lower limit value described in a certain numerical range may be replaced with a value shown in Examples.

In the present disclosure, a combination of two or more preferred embodiments is a more preferred embodiment.

In a case in which a plurality of kinds of substances corresponding to each component are present, in the present disclosure, the amount of each component refers to the total amount of the plurality of kinds of substances, unless otherwise specified.

In the present specification, the term "step" not only refers to an independent step, but also includes a step that is not clearly distinguishable from another step as long as a desired object of the step is achieved.

In the present disclosure, the term "EUV light" refers to light having a wavelength of from 1 nm to 30 nm. EUV light preferably has a wavelength of from 5 nm to 13.5 nm.

The pellicle case, the pellicle assembly and the pellicle inspection method according to the embodiments of the present disclosure will be described below with reference to drawings. In the drawings, identical or corresponding parts are denoted with identical reference numerals and the description thereof will not be repeated.

### (1) Pellicle Case

The pellicle case according to the present disclosure is a pellicle case for housing a pellicle including a pellicle film in a sealed state. This pellicle case includes a body and a lid. The body has a first planar window for inspecting the pellicle film. The lid has a second planar window for inspecting the pellicle film. The second planar window is disposed opposite to the first planar window. The pellicle case according to the present disclosure satisfies at least one of the following requirement (a) or (b):
(a) a light shielding layer is formed on at least a portion of the outer surface of one of the first planar window or the second planar window,
   in which a planar window, among the first planar window and the second planar window, on a side on which the light shielding layer is not formed has a transmittance for light having a wavelength of from 0.4 µm to 0.7 µm of 75% or more, and
   in which the light shielding layer has a reflectance for light having a wavelength of from 0.4 µm to 0.6 µm of 5% or less; or
(b) each of the first planar window and the second planar window has a transmittance for light having a wavelength of from 2 µm to 10 µm of 70% or more.

In the present disclosure, the term "planar window" refers to a window in the form of a planar substrate. The "transmittance" can be determined from light intensity measured in the presence of the planar window and light intensity measured in the absence of the planar window, for light having a wavelength to be measured. The light intensity can be measured in a dark box that prevents the entry of external light. The light intensity can be measured using a spectrophotometer (such as "PHOTO RT" manufactured by Tokyo Instruments, Inc.) or a Fourier transformation infrared spectrophotometer (such as CARY 600 series manufactured by Agilent Technologies Inc.). The transmittance of a resin window for light having a wavelength of from 2 µm to 10 µm is usually less than 70%. The fact that the pellicle case according to the present disclosure satisfies the requirement (b) indicates that the material of each of the first planar window and the second planar window is not a resin.

Since the pellicle case according to the present disclosure has the configuration as described above, the pellicle case allows for the inspection of the pellicle film housed therein in a sealed state.

This effect is assumed to be due to the following reasons, but not limited thereto.

The measurement of the G/D ratio by Raman spectroscopy is usually carried out by irradiating excitation light having a wavelength of 532 nm to the pellicle film, and detecting Raman scattered light generated by the irradiation through the planar window through which the excitation light has been irradiated (namely, as a reflected light). The wavelength of the Raman scattered light is different from the wavelength of the excitation light. The fact that the pellicle case satisfies the requirement (a) indicates that each of the first planar window and the second planar window does not easily absorb the excitation light and the Raman scattered light, and that the light shielding layer easily absorbs the excitation light and the Raman scattered light. This makes it easier to accurately detect the Raman scattered light. In other words, the G/D ratio can be measured more accurately. As a result, the pellicle case according to the present disclosure makes it possible to inspect whether or not any defects are present in the CNTs included in the pellicle film (CNT film) housed therein in a sealed state.

The measurement of the emissivity of the pellicle film by the FTIR method is usually carried out by irradiating continuous light having a wavelength of from 1 µm to 10 µm to the pellicle film, and detecting the emissivity resulting from the irradiation through the first planar window or the second planar window, using a spectral emissivity measurement device. The fact that the pellicle case satisfies the requirement (b) indicates that each of the first planar window and the second planar window does not easily absorb the continuous light. This makes it easier to accurately detect the emissivity. As a result, the pellicle case according to the present disclosure makes it possible to inspect whether or not any gas is adsorbed onto the pellicle film housed therein in a sealed state.

The pellicle case has a space (hereinafter, also referred to as "housing space") for housing a pellicle, in the interior thereof. The housing space is formed by the body and the lid.

The shape and the size of the pellicle case are not particularly limited, and can be selected as appropriate depending on the pellicle to be housed.

### (1. 1) Body

The pellicle case according to the present disclosure includes a body. The pellicle to be housed is placed in the body. The shape and the size of the body are not particularly limited, and can be selected as appropriate depending on the pellicle to be housed, and the like.

### (1. 1. 1) First Planar Window

The body has a first planar window for inspecting the pellicle film.

The shape of the first planar window is not particularly limited. The first planar window may be, for example, in the form of a circle, a polygon (such as a triangle, a quadrangle, a pentagon, a hexagon, or a heptagon), or in an irregular form.

The size of the first planar window is not particularly limited, and can be selected as appropriate depending on the method of inspecting the pellicle film, and the like. In a case in which the first planar window is in the form of a circle, the size of the first planar window may be from 1 mm to 10 mm in diameter. The thickness of the first planar window is not particularly limited, and can be selected as appropriate depending on the method of inspecting the pellicle film, and the like.

The number of the first planar windows is not particularly limited, and can be selected as appropriate depending on the size of the first planar window, and the like. The body may have one first planar window, or two or more first planar windows.

The arrangement position of the first planar window is not particularly limited. The arrangement position of the first planar window is preferably a position that is opposite to a portion of the periphery of a main surface of the pellicle film included in the pellicle to be housed. There is a case in which the pellicle includes: a pellicle frame; and a tackifying layer for attaching the pellicle to a photomask substrate, which is provided at an end of the pellicle frame. The periphery of the main surface of the pellicle film included in the pellicle is more susceptible to contamination as compared to the central portion of the main surface of the pellicle film, due to the presence of the tackifying layer, and the like. When the arrangement position of the first planar window is a position that is opposite to a portion of the periphery of the main surface of the pellicle film included in the pellicle to be housed, the pellicle case according to the present disclosure makes it possible to improve the efficiency of the inspection of the pellicle film housed therein in a sealed state.

The material of the first planar window will be described later.

### (1. 1. 2) First Wall

The body may further include a first wall. It is preferred that the first wall has a first through-hole, and that the first planar window is fitted into the first through-hole and fixed in place. By this arrangement, the generation of gas is less likely to occur in the pellicle case according to the present disclosure, as compared to the case in which the first planar window is fixed in the first through-hole by an adhesive. As a result, the pellicle case according to the present disclosure allows for a more accurate inspection of the pellicle film.

The shape and the size of the first wall are not particularly limited, and can be selected as appropriate depending on the pellicle to be housed. The material of the first wall is not particularly limited, and may be, for example, a metal or a resin.

### (1. 2) Lid

The pellicle case according to the present disclosure includes a lid. The lid is coupled to the body to form the housing space for housing a pellicle. The shape and the size of the lid are not particularly limited, and can be selected as appropriate depending on the pellicle to be housed.

### (1. 2. 1) Second Planar Window

The body has a second planar window for inspecting the pellicle film.

The second planar window may be the same as that exemplified as the first planar window, except that the second planar window is disposed opposite to the first planar window. The second planar window may be identical with, or different from, the first planar window. The material of the second planar window will be described later.

### (1. 2. 2) Second Wall

The lid may further include a second wall. It is preferred that the second wall has a second through-hole, and that the second planar window is fitted into the second through-hole and fixed in place. By this arrangement, the generation of gas is less likely to occur in the pellicle case according to the present disclosure, as compared to the case in which the second planar window is fixed in the second through-hole by an adhesive. As a result, the pellicle case according to the present disclosure allows for a more accurate inspection of the pellicle film.

The shape and the size of the second wall are not particularly limited, and can be selected as appropriate depending on the pellicle to be housed. The material of the second wall is not particularly limited, and may be, for example, a metal or a resin. The material of the second wall may be identical with, or different from, the material of the first wall.

### (1. 3) Requirement (a)

In a case in which the pellicle case according to the present disclosure satisfies the requirement (a), each of the first planar window and the second planar window has a transmittance (hereinafter, also referred to as "first transmittance") for light having a wavelength of from 0.4 µm to 0.7 µm of 75% or more, and preferably 90% or more. When the first transmittance is 90% or more, the pellicle case according to the present disclosure allows for a more accurate inspection of the pellicle film.

Examples of the material that controls the first transmittance to 75% or more include potassium bromide (KBr), sapphire, thallium bromochloride (such as "KRS-6" manufactured by Crystal Base Co., Ltd.), fluoride and alkali halide single crystals, zinc sulfide (ZnS), and fused quartz (such as "IR GRADE" manufactured by NEOTRON CO., LTD.).

Examples of the material that controls the first transmittance to 90% or more include thallium bromochloride and fused lime.

In a case in which the pellicle case according to the present disclosure satisfies the requirement (a), the material of each of the first planar window and the second planar window is preferably KBr, sapphire, ZnS, or fused quartz.

In a case in which the material of the first planar window has hygroscopicity, dip coating (provided by Toa Optical Technologies, LTD.) that prevents moisture absorption may be performed on the first planar window.

In a case in which the pellicle case according to the present disclosure satisfies the requirement (a), a light shielding layer is formed on at least a portion of the outer surface of one of the first planar window or the second planar window. The method of fixing the light shielding layer on one of the first planar window or the second planar window is not particularly limited, and may be, for example, a welding method, a method using a known adhesive, or mechanical fastening.

The light shielding layer has a reflectance (hereinafter, also simply referred to as "reflectance") for light having a wavelength of from 0.4 µm to 0.6 µm of 5% or less.

Examples of the material that controls the reflectance to 5% or less include butyl rubber (to which carbon black is added), black anodized aluminum, chromate-treated films, black iron oxide, black stainless steel, black titanium, black lacquer, and carbon nanotube films.

In a case in which the pellicle case according to the present disclosure satisfies the requirement (a), the material of the light shielding layer is preferably black anodized aluminum, black iron oxide, black stainless steel, or black titanium.

### (1. 4) Requirement (b)

In a case in which the pellicle case according to the present disclosure satisfies the requirement (b), each of the first planar window and the second planar window has a transmittance (hereinafter, also referred to as "second transmittance") for light having a wavelength of from 2 µm to 10 µm of 70% or more, and each of the first planar window and the second planar window preferably has a transmittance (hereinafter, also referred to as "third transmittance") for light having a wavelength of from 1 µm to 20 µm of 70% or more. When the third transmittance is 70% or more, the pellicle case according to the present disclosure allows for a more accurate inspection of the pellicle film.

Examples of the material that controls the second transmittance to 70% or more include potassium bromide (KBr), sapphire, thallium bromochloride (such as "KRS-6" manufactured by Crystal Base Co., Ltd.), fluoride and alkali halide single crystals, zinc sulfide (ZnS), and fused quartz (such as "IR GRADE" manufactured by NEOTRON CO., LTD.).

Examples of the material that controls the third transmittance to 70% or more include KBr and KRS-6.

In a case in which the pellicle case according to the present disclosure satisfies the requirement (b), the material of each of the first planar window and the second planar window is preferably KBr, sapphire, KRS-6, or ZnS.

In a case in which the material of the second planar window is hygroscopic, dip coating (provided by Toa Optical Technologies, LTD.) that prevents moisture absorption may be performed.

### (1. 5) Pressure Equalization Mechanism

It is preferred that at least one of the body or the lid further includes a pressure equalization mechanism for equalizing the pressure in the interior (namely, the housing space) of the pellicle case in a sealed state. The pressure equalization mechanism has: a vent passage that communicates the interior and the exterior of the pellicle case; a valve capable of opening and closing the vent passage; and a filter disposed in the vent passage. The filter is located at a position closer to the interior side of the pellicle case than the valve.

There is a risk that the pellicle film may be damaged by the pressure due to the local pressure difference in the housing space, when retrieving the pellicle housed in the pellicle case in a sealed state. When at least one of the body or the lid further includes a pressure equalization mechanism, it is possible to equalize the pressure in the housing space of the pellicle case. By this arrangement, the pressure due to the local pressure difference in the housing space is less likely to occur. As a result, the pellicle case according to the present disclosure makes it possible, when retrieving the pellicle housed in the pellicle case in a sealed state, to reduce the occurrence of damage to the pellicle film.

The vent passage communicates the exterior of the pellicle case with the housing space. The number of the vent passages is not particularly limited, and one or a plurality of vent passages may be included.

The valve is capable of opening and closing the vent passage. Any known valve can be used as the valve. The valve may be provided at an inlet on the exterior side of the pellicle case, of the vent passage, or may be provided in the vent passage.

The filter prevents the entry of foreign substances into the housing space from the exterior of the pellicle case, when the valve is open. Any known filter that passes gas but does not pass foreign substances (such as dust and the like) can be used as the filter.

### (1. 6) Airtight Seal

The pellicle case according to the present disclosure may further include an airtight seal. This improves the hermeticity of the pellicle case according to the present disclosure. The airtight seal may be, for example, a gasket (such as an O-ring) interposed between the body and the lid, or a metal coating that covers a contact portion between the body and the lid.

### (1. 7) Fasteners

The pellicle case according to the present disclosure may further include fasteners. The fasteners fasten the lid to the body so that the pellicle can be housed in the pellicle case in a sealed state. Any known fasteners can be used as the fasteners.

### (1. 8) Support Member

The pellicle case according to the present disclosure may further include a support member. The support member is attached to at least one of the body or the lid. The support member supports and secures the pellicle in the pellicle case. This makes it possible to prevent the pellicle housed in the pellicle case according to the present disclosure from moving within the pellicle case, and to reduce the adhesion of foreign substances to the pellicle film. The support member may include: a contact part that comes into contact with the pellicle; and a displacement mechanism (such as a flat spring) that enables the displacement of the contact part. The material of the contact part may be, for example, a thermoplastic elastomer (such as a polyester elastomer or a polybutylene terephthalate elastomer) or a fluororesin, from the viewpoint of mitigating the shock when the pellicle is placed on the contact part. Any known support member can be used as the support member.

### (1. 9) Preferred Aspects

### (1. 9. 1) First Aspect

The pellicle case according to the present disclosure preferably has a configuration (a1). The configuration (a1) indicates that the pellicle case satisfies the requirement (a), and that the light shielding layer is formed on the entire outer surface of one of the first planar window or the second planar window. When the pellicle case according to the present disclosure satisfies the configuration (a1), the pellicle case according to the present disclosure makes it possible to inspect whether or not any defects are present in the CNTs included in the pellicle film (CNT film) housed therein in a sealed state.

### (1. 9. 2) Second Aspect

The pellicle case according to the present disclosure preferably has a configuration (a2). The configuration (a2) indicates that the pellicle case satisfies the requirement (a), and that the light shielding layer is formed on a portion of the outer surface of one of the first planar window or the second planar window. When the pellicle case according to the present disclosure satisfies the configuration (a2), the pellicle case according to the present disclosure allows for the inspection of the pellicle film housed therein in a sealed state, by Raman spectroscopy and the FTIR method. In other words, the pellicle case according to the present disclosure makes it possible to inspect whether or not any defects are present in the CNTs included in the pellicle film (CNT film) housed therein in a sealed state, and also makes it possible to inspect whether or not any gas is adsorbed onto the pellicle film housed therein in a sealed state. Specifically, by irradiating excitation light to the pellicle film (CNT film) in such a manner that the excitation light and the Raman scattered light are incident on the light shielding layer, the pellicle case according to the present disclosure makes it possible to inspect whether or not any defects are present in the CNTs included in the pellicle film (CNT film) housed therein in a sealed state. By irradiating continuous light to the pellicle film in such a manner that the continuous light is not incident on the light shielding layer, on the other hand, the pellicle case according to the present disclosure makes it possible to inspect whether or not any gas is adsorbed onto the pellicle film housed therein in a sealed state.

In a case in which the pellicle case satisfies the configuration (a2), each of the first planar window and the second planar window has a transmittance (hereinafter, also referred to as "fourth transmittance") for light having a wavelength of from 0.5 µm to 20 µm of 50% or more, and preferably 60% or more. When the fourth transmittance is 70% or more, the pellicle case according to the present disclosure allows for the inspection of the pellicle film, by Raman spectroscopy and the FTIR method.

Examples of the material that controls the fourth transmittance to 50% or more include KBr and KRS-6.

Examples of the material that controls the fourth transmittance to 70% or more include KBr.

In a case in which the pellicle case according to the present disclosure satisfies the configuration (a1), the material of each of the first planar window and the second planar window is preferably KBr, sapphire, ZnS, or fused quartz.

### (1. 9. 3) Third Aspect

The pellicle case according to the present disclosure preferably satisfies the configuration (a2), and also satisfies the requirement (b). When the pellicle case according to the present disclosure satisfies the configuration (a2) and the requirement (b), the pellicle case according to the present disclosure allows for the inspection of the pellicle film housed therein in a sealed state, by Raman spectroscopy and the FTIR method.

### (1. 9. 4) Fourth Aspect

The pellicle case according to the present disclosure preferably satisfies the requirement (b). By this arrangement, the pellicle case according to the present disclosure makes it possible to inspect whether or not any gas is adsorbed onto the pellicle film housed therein in a sealed state.

### (2) Pellicle Assembly

The pellicle assembly according to the present disclosure includes: the pellicle case according to the present disclosure; and a pellicle housed in the pellicle case in a sealed state. The pellicle includes a pellicle film. The first planar window is disposed opposite to the second planar window with the pellicle film interposed therebetween.

Since the pellicle assembly according to the present disclosure has the configuration as described above, the pellicle assembly allows for the inspection of the pellicle film housed therein in a sealed state.

The pellicle assembly according to the present disclosure can be obtained by being assembled, for example, in a clean room under a nitrogen atmosphere. The pellicle may be housed in the pellicle case in a vacuum sealed state.

### (2. 1) Pellicle

The pellicle usually includes a pellicle film, and a pellicle frame. The pellicle film is provided so as to stretch over the pellicle frame, at one end of the pellicle frame in the height direction of the pellicle frame.

In a case in which the pellicle case includes a support member, the pellicle may be in a state secured by the support member and coupled to the body and the lid, in the pellicle case.

### (2. 1. 1) Pellicle Film

The pellicle includes a pellicle film. The pellicle film prevents the adhesion of foreign substances to the surface of a photomask substrate, and transmits exposure light during exposure. Foreign substances include dust. The exposure light may be, for example, deep-ultraviolet (DUV) light or EUV light. The EUV light refers to light having a wavelength of from 5 nm to 30 nm.

The pellicle film covers the entire opening of the through-hole of the pellicle frame. The pellicle film may be supported directly, or may be supported via an adhesive layer, on one end of the pellicle frame. The adhesive layer may be a cured product of a known adhesive.

The pellicle film preferably has a film thickness of from 1 nm to 300 nm. The material of the pellicle film is not particularly limited, and may be, for example, a cellulose-based resin, a fluororesin, a carbon-based material, SiN, a polysilicon or boron nitride, depending on an exposure light source to be used. Carbon-based materials include carbon nanotubes (hereinafter, each also referred to as "CNT"). In particular, the pellicle film preferably includes a nanotube, more preferably includes a CNT or boron nitride, and still more preferably includes a CNT. The nanotube may be a single-wall nanotube or a multi-wall nanotube, and may include a single-wall nanotube and a multi-wall nanotube. The pellicle film may have a nonwoven fabric structure. The nonwoven fabric structure is formed, for example, by nanotubes in the form of fibers. The pellicle film may be a known pellicle film.

### (2. 1. 2) Pellicle Frame

The pellicle frame is a cylindrical object. The pellicle frame has a through-hole. The through-hole refers to a space through which the exposure light transmitted through the pellicle film passes in order to reach to a photomask substrate.

The shape of the pellicle frame corresponds to the shape of the photomask substrate. The shape of the pellicle frame seen from the height direction is not particularly limited, and may be, for example, in the form of a rectangular frame (for example, in the form of an oblong frame, or in the form of a square frame).

The pellicle frame can have any known size, depending on the type of exposure light.

The pellicle frame may have a ventilation hole, or may not have a ventilation hole. The ventilation hole communicates the interior space of the pellicle with the exterior space of the pellicle, when the pellicle frame is attached to a photomask substrate. The expression "interior space of the pellicle" refers to a space surrounded by the pellicle and the photomask substrate. The expression "exterior space of the pellicle" refers to a space not surrounded by the pellicle and the photomask substrate.

Examples of the material of the pellicle frame include aluminum, titanium, stainless steel, ceramic-based materials (such as silicon and glass), and resins (such as polyethylene).

### (3) Pellicle Inspection Method

The pellicle inspection method according to the present disclosure (hereinafter, also referred to as "first inspection method") is a method of inspecting the pellicle housed in the pellicle assembly according to the present disclosure in a sealed state. The pellicle case satisfies the requirement (a). The pellicle film includes a plurality of carbon nanotubes. The first inspection method includes irradiating excitation light to the pellicle film through the other one of the first planar window or the second planar window, to measure the intensity of the D band and the intensity of the G band, by Raman spectroscopy (hereinafter, also referred to as "first measurement step").

Since the first inspection method has the configuration as described above, the first inspection method is capable of easily inspecting the pellicle film housed in the pellicle case in a sealed state. Specifically, the first inspection method is capable of measuring the G/D ratio of the pellicle film housed in the pellicle case in a sealed state. In other words, the first inspection method is capable of inspecting whether or not any defects are present in the CNTs included in the CNT film. For example, it is possible to reliably irradiate light onto a semiconductor wafer in a desired pattern, by using a pellicle that has been determined to have no defect in the CNTs, and not using a pellicle that has been determined to have some defects in the CNTs. It is possible to clean the pellicle that has been determined to have some defects in the CNTs, by heating the pellicle to a temperature of more than 2,000°C (see Non-Patent Document 1). It is possible to reliably irradiate light onto a semiconductor wafer in a desired pattern, by using the cleaned pellicle.

### (3. 1) First Measurement Step

In the first measurement step, excitation light is irradiated to the pellicle film through the other one of the first planar window or the second planar window, to measure the ratio of the intensity of the G band to the intensity of the D band, by Raman spectroscopy.

Any method using a known Raman spectrometer can be used as the measurement method by Raman spectroscopy. The excitation light usually has a wavelength of 532 nm.

### (4) Pellicle Inspection Method

The pellicle inspection method according to the present disclosure (hereinafter, also referred to as "second inspection method") is a method of inspecting the pellicle housed in the pellicle assembly according to the present disclosure in a sealed state. The pellicle case satisfies the requirement (b). The second inspection method incudes irradiating continuous light to the pellicle film through one of the first planar window or the second planar window, to measure the emissivity by Fourier-transform infrared spectroscopy (hereinafter, also referred to as "second measurement step").

Since the second inspection method has the configuration as described above, the second inspection method is capable of easily inspecting the pellicle film housed in the pellicle case in a sealed state. Specifically, the second inspection method is capable of measuring the emissivity of the pellicle film housed in the pellicle case in a sealed state. In other words, the second inspection method is capable of inspecting whether or not any gas is adsorbed onto the pellicle film. For example, it is possible to reliably irradiate light onto a semiconductor wafer in a desired pattern, by using a pellicle that has been determined to have no gas adsorption onto the pellicle film, and not using a pellicle that has been determined to have some gas adsorption onto the pellicle film. It is possible to clean the pellicle that has been determined to have some gas adsorption onto the pellicle film, by heating the pellicle to a temperature of more than 2,000°C (see Non-Patent Document 1). It is possible to reliably irradiate light onto a semiconductor wafer in a desired pattern, by using the cleaned pellicle.

### (4. 1) Second Measurement Step

In the second measurement step, continuous light is irradiated to the pellicle film through one of the first planar window or the second planar window, to measure the emissivity by the FTIR method.

Any method using a known spectral emissivity measurement device (such as "JIR-E500" manufactured by JEOL Ltd.) can be used as the measurement method by the FTIR method. The continuous light usually has a wavelength of from 1 µm to 10 µmm.

### (5) First Embodiment

### (5.1) Pellicle Assembly

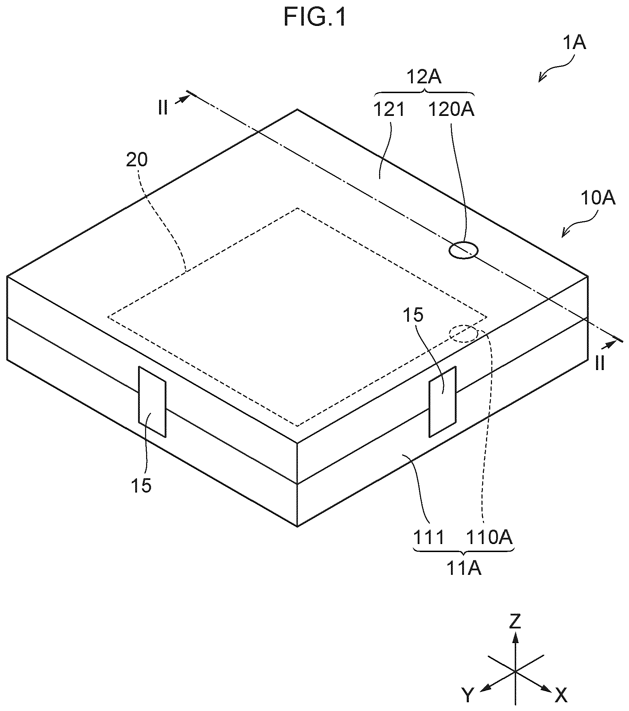

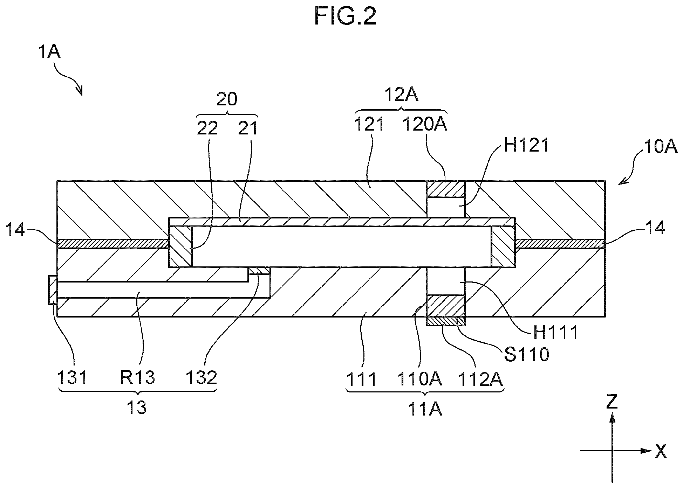

As shown in FIG. 1 and FIG. 2, a pellicle assembly 1A according to the first embodiment includes a pellicle case 10A and a pellicle 20. The pellicle 20 is housed in the pellicle case 10A in a sealed state. The pellicle assembly 1A is an object in the form of a rectangular parallelepiped.

Hereinafter, the longitudinal direction of the main surface of the pellicle assembly 1A is defined as "X-axis direction", the transverse direction of the main surface of the pellicle assembly 1A is defined as "Y-axis direction", and the thickness direction of the pellicle assembly 1A is defined as "Z-axis direction". The X axis, the Y axis and the Z axis are orthogonal to one another. These directions do not limit the directions during the use of the pellicle assembly according to the present disclosure.

### (5. 1. 1) Pellicle

As shown in FIG. 2, the pellicle 20 includes a pellicle film 21 and a pellicle frame 22. The pellicle film 21 is in the form of an oblong. The pellicle film 21 contains CNTs. The pellicle frame 22 is an object in the form of an oblong frame. The longitudinal directions of the pellicle film 21 and the pellicle frame 22 are parallel to the X-axis direction. The transverse directions of the pellicle film 21 and the pellicle frame 22 are parallel to the Y-axis direction.

### (5. 1. 2) Pellicle Case

The pellicle case 10A is a pellicle case for housing the pellicle 20 including the pellicle film 21 (see FIG. 2) in a sealed state. The pellicle case 10A includes a body 11A, a lid 12A, a pressure equalization mechanism 13 (see FIG. 2), an airtight seal 14 (see FIG. 2), and fasteners 15.

### (5.1.2.1) Body

The body 11A is a bowl-shaped object. The body 11A has one first planar window 110A, a first wall 111, and a light shielding layer 112A.

The first planar window 110A is disposed opposite to a portion of the periphery of the main surface of the pellicle film 21. The first transmittance of the first planar window 110A is 75% or more. The first planar window 110A is in the form of a circle. The first planar window 110A may have a diameter of from 1 mm to 10 mm.

The first wall 111 has a first through-hole H111 (see FIG. 2). The first planar window 110A is fitted into the first through-hole H111 and fixed in place.

The light shielding layer 112A is formed on an outer surface S110 of the first planar window 110A. The light shielding layer 112A covers the entire outer surface S110 of the first planar window 110A. The reflectance of the light shielding layer 112A is 5% or less.

### (5. 1. 2. 2) Lid

The lid 12A is a bowl-shaped object. The lid 12A has one second planar window 120A, and a second wall 121.

The second planar window 120A is disposed opposite to the first planar window 110A with the pellicle film 21 interposed therebetween in the Z-axis direction. The first transmittance of the second planar window 120A is 75% or more. The second planar window 120A is in the form of a circle. The second planar window 120A may have a diameter of from 1 mm to 10 mm.

The second wall 121 has a second through-hole H121 (see FIG. 2). The second planar window 120A is fitted into the second through-hole H121 and fixed in place.

### (5. 1. 2. 3) Pressure Equalization Mechanism

The body 11A includes the pressure equalization mechanism 13. The pressure equalization mechanism 13 is used for adjusting the pressure in the interior of the pellicle case 10A in a sealed state, to the atmospheric pressure. The pressure equalization mechanism 13 has a vent passage R13, a valve 131, and a filter 132.

The vent passage R13 communicates the interior and the exterior of the pellicle case 10A. The vent passage R13 is formed in the first wall 111 of the body 11A.

The valve 131 is capable of opening and closing the vent passage R13. The valve 131 is attached to the inlet on the exterior side of the pellicle case 10A, of the vent passage R13. The valve 131 is a known valve.

The filter 132 is disposed in the vent passage R13. The filter 132 is located at a position closer to the interior side of the pellicle case 10A than the valve 131. The filter 132 is a known filter (such as a high-efficiency particulate air (HEPA) vent filter, or an ultra-low penetration air (ULPA) vent filter).

### (5. 1. 2. 4) Airtight Seal

The airtight seal 14 is interposed between the body 11A and the lid 12A. The airtight seal 14 is a known gasket (such as an O-ring).

### (5. 1. 2. 5) Fasteners

The fasteners 15 fasten the lid 12A to the body 11A so that the pellicle 20 can be housed in the pellicle case 10A in a sealed state. Any known fasteners can be used as the fasteners.

### (5. 2) First Inspection Method

The first inspection method according to the first embodiment includes the first measurement step. In the first measurement step, excitation light is irradiated to the pellicle film 21 through the second planar window 120A, to measure the ratio of the intensity of the G band to the intensity of the D band, by Raman spectroscopy. Specifically, a Raman spectrometer is used to irradiate excitation light to the pellicle film 21 through the second planar window 120A, and to detect the Raman scattered light through the second planar window 120A. Then the intensity of the D band and the intensity of the G band are read from a Raman spectrum based on the thus detected Raman scattered light. The G/D ratio can be obtained by using the intensity of the D band and the intensity of the G band that have been read.

### (5. 3) Mechanism and Effect

As has been described with reference to FIG. 1 and FIG. 2, the pellicle case 10A includes the body 11A and the lid 12A. The body 11A has the first planar window 110A. The lid 12A has the second planar window 120A. The second planar window 120A is disposed opposite to the first planar window 110A. The pellicle case 10A satisfies the following requirement (a).
(a) The light shielding layer 112A is formed on the entire outer surface S110 of the first planar window 110A, the second planar window 120A has a transmittance for light having a wavelength of from 0.4 µm to 0.7 µm of 75% or more, and the light shielding layer 112A has a reflectance for light having a wavelength 0.4 µm to 0.6 µm of 5% or less.

This allows for the inspection of the pellicle film 21 housed in the pellicle case 10A in a sealed state. Specifically, the G/D ratio can be measured more accurately, by using the pellicle case 10A. As a result, the pellicle case 10A makes it possible to inspect whether or not any defects are present in the CNTs included in the pellicle film 21 housed therein in a sealed state.

As has been described with reference to FIG. 1 and FIG. 2, the light shielding layer 112A is formed on the entire outer surface S110 of the first planar window 110A.

This makes it possible to inspect whether or not any defects are present in the CNTs included in the pellicle film 21 housed in the pellicle case 10A in a sealed state.

As has been described with reference to FIG. 1 and FIG. 2, the body 11A further includes the pressure equalization mechanism 13.

This makes it possible to gradually increase the pressure in the pellicle case 10A to the atmospheric pressure. Therefore, the pressure due to the pressure difference is less likely to occur, even when the pellicle case 10A is opened in the atmosphere. As a result, the pellicle case 10A makes it possible, when retrieving the pellicle 20 housed in the pellicle case 10A in a sealed state, to reduce the occurrence of damage to the pellicle film 21.

As has been described with reference to FIG. 1 and FIG. 2, the pellicle assembly 1A includes the pellicle case 10A, and the pellicle 20. The first planar window 110A is disposed opposite to the second planar window 120A with the pellicle film 21 interposed therebetween.

This allows for the inspection of the pellicle film 21 housed in the pellicle assembly 1A in a sealed state.

As has been described with reference to FIG. 1 and FIG. 2, the first inspection method according to the first embodiment includes the first measurement step.

This makes the first inspection method according to the first embodiment capable of easily inspecting the pellicle film 21 housed in the pellicle case 10A in a sealed state.

### (6) Second Embodiment

### (6. 1) Pellicle Assembly

A pellicle assembly 1B according to the second embodiment has the same configuration as that of the pellicle assembly 1A according to the first embodiment, except that the material of the first planar window is different from that of the second planar window, and that no light shielding layer is formed.

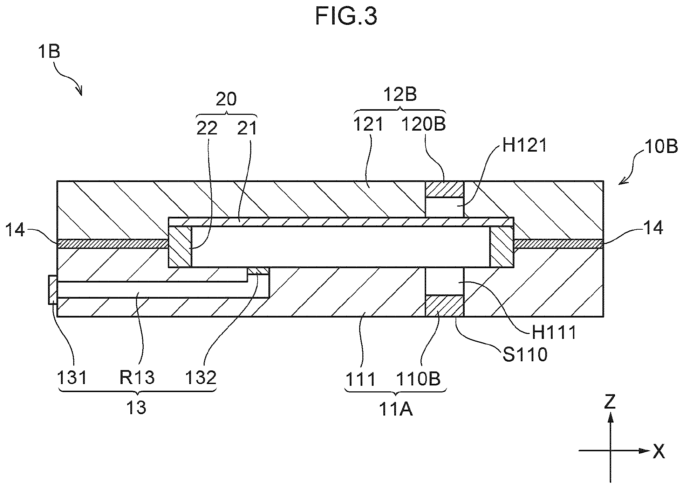

As shown in FIG. 3, the pellicle assembly 1B according to the second embodiment includes a pellicle case 10B, and the pellicle 20.

### (6. 1. 1) Pellicle Case

The pellicle case 10B has the same configuration as that of the pellicle case 10A according to the first embodiment, except that the material of the first planar window is different from that of the second planar window, and that no light shielding layer is formed.

The pellicle case 10B includes a body 11B, a lid 12B, the pressure equalization mechanism 13, the airtight seal 14, and the fasteners 15.

### (6. 1. 1. 1) Body

The body 11B has one first planar window 110B, and the first wall 111.

The first planar window 110B has the same configuration as that of the first planar window 110A, except for having a second transmittance of 70% or more.

### (6. 1. 1. 2) Lid

The lid 12B includes one second planar window 120B, and the second wall 121.

The second planar window 120B has the same configuration as that of the second planar window 120A, except for having a second transmittance of 70% or more.

### (6. 2) First Inspection Method

The second inspection method according to the second embodiment includes the second measurement step. In the second measurement step, continuous light is irradiated to the pellicle film 21 through the second planar window 120B, to measure the emissivity by the FTIR method. Specifically, a spectral emissivity measurement device is used to irradiate continuous light to the pellicle film 21 through the second planar window 120B, and to detect the reflected light through the second planar window 120B, and at the same time, to detect the transmitted light thorough the first planar window 120A. The emissivity can be obtained using the thus detected reflected light and transmitted light.

### (6. 3) Mechanism and Effect

As has been described with reference to FIG. 3, the pellicle case 10B includes the body 11B and the lid 12B. The body 11B has the first planar window 110B. The lid 12B has the second planar window 120B. The second planar window 120B is disposed opposite to the first planar window 110B. The pellicle case 10B satisfies the following requirement (b).

(b) Each of the first planar window 120A and the second planar window 120B has a transmittance for light having a wavelength of from 2 µm to 10 µm of 70% or more.

This allows for the inspection of the pellicle film 21 housed in the pellicle case 10B in a sealed state. Specifically, the emissivity can be measured more accurately, by using the pellicle case 10B. As a result, the pellicle case 10B makes it possible to inspect whether or not any defects are present in the CNTs included in the pellicle film 21 housed therein in a sealed state.

As has been described with reference to FIG. 3, the second inspection method according to the second embodiment includes the second measurement step.

This makes the second inspection method according to the second embodiment capable of easily inspecting the pellicle film 21 housed in the pellicle case 10B in a sealed state.

### (7) Third Embodiment

### (7. 1) Pellicle Assembly

A pellicle assembly 1C according to the third embodiment has the same configuration as that of the pellicle assembly 1A according to the first embodiment, except that the light shielding layer is formed on a portion of the first planar window.

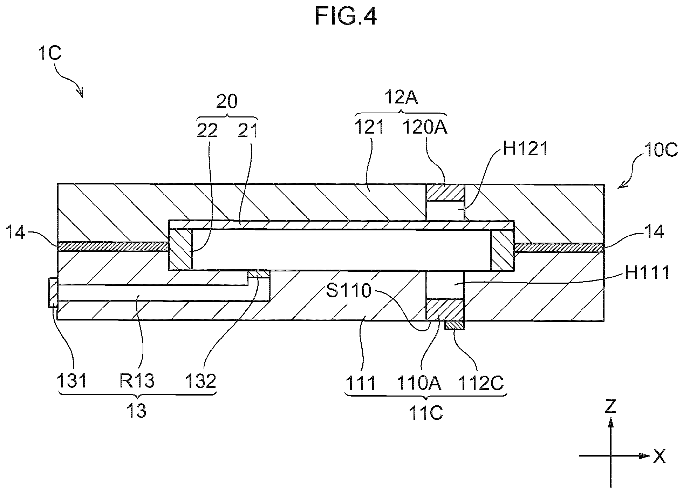

As shown in FIG. 4, the pellicle assembly 1C according to the third embodiment has a pellicle case 10C, and the pellicle 20.

### (7. 1. 1) Pellicle Case

The pellicle case 10C has the same configuration as that of the pellicle case 10A according to the first embodiment, except that the light shielding layer is formed on a portion of the first planar window.

The pellicle case 10C includes a body 11C, the lid 12A, the pressure equalization mechanism 13, the airtight seal 14, and the fasteners 15.

### (7. 1. 1. 1) Body

The body 11B has one first planar window 110A, the first wall 111, and a light shielding layer 112C.

The light shielding layer 112C has the same configuration as that of the light shielding layer 112A, except that the light shielding layer 112C covers a half of the outer surface S110 of the first planar window 110A in the positive X-axis direction.

Hereinafter, the region of the outer surface S110 of the first planar window 110A on which the light shielding layer 112C is formed, is also referred to as "light-shielding region", and the region of the outer surface S110 on which the light shielding layer 112C is not formed, is also referred to as "non-light-shielding region".

### (7. 2) First Inspection Method

The first inspection method according to the third embodiment includes the first measurement step. In the first measurement step, excitation light is irradiated to the pellicle film 21 through the second planar window 120A, to measure the ratio of the intensity of the G band to the intensity of the D band, by Raman spectroscopy. Specifically, a Raman spectrometer is used to irradiate excitation light to the pellicle film 21 through the second planar window 120A, and to detect the Raman scattered light through the second planar window 120A. At this time, the excitation light is irradiated in such a manner that the light transmitted through the pellicle film 21, of the excitation light, is efficiently irradiated to the light-shielding region. The intensity of the D band and the intensity of the G band are read from the Raman spectrum based on the thus detected Raman scattered light. The G/D ratio can be obtained by using the intensity of the D band and the intensity of the G band that have been read.

### (7. 3) Second Inspection Method

The second inspection method according to the third embodiment includes the second measurement step. In the second measurement step, continuous light is irradiated to the pellicle film 21 through the second planar window 120B, to measure the emissivity by the FTIR method. Specifically, a spectral emissivity measurement device is used to irradiate continuous light to the pellicle film 21 through the second planar window 120B, and to detect the reflected light through the second planar window 120B, and at the same time, to detect the transmitted light thorough the non-light-shielding region of the first planar window 120A. The emissivity can be obtained using the thus detected reflected light and transmitted light.

### (7. 4) Mechanism and Effect

As has been described with reference to FIG. 4, the pellicle case 10C includes the body 11C, and the lid 12A. The body 11C has the first planar window 110A. The lid 12A has the second planar window 120A. The second planar window 120A is disposed opposite to the first planar window 110A. The pellicle case 10C satisfies the following requirement (a).
(a) The light shielding layer 112A is formed on a portion of the outer surface S110 of the first planar window 110A, the second planar window 120A has a transmittance for light having a wavelength of from 0.4 µm to 0.7 µm of 75% or more, and the light shielding layer 112C has a reflectance for light having a wavelength 0.4 µm to 0.6 µm of 5% or less.

This allows for the inspection of the pellicle film 21 housed in the pellicle case 10C in a sealed state, by Raman spectroscopy and the FTIR method. Specifically, the pellicle case 10C makes it possible to inspect whether or not any defects are present in the CNTs included in the pellicle film 21 housed therein in a sealed state, and also makes it possible to inspect whether or not any gas is adsorbed onto the pellicle film 21 housed therein in a sealed state. Specifically, by irradiating excitation light to the pellicle film 21 in such a manner that the excitation light and the Raman scattered light are incident on the light shielding layer 112C (namely, incident on the light-shielding region), the pellicle case 10C makes it possible to inspect whether or not any defects are present in the CNTs included in the pellicle film 21 housed therein in a sealed state. On the other hand, by irradiating continuous light to the pellicle film 21 in such a manner that the continuous light is not incident on the light shielding layer 112C (namely, incident on the non-light-shielding region), the pellicle case 10C makes it possible to inspect whether or not any gas is adsorbed onto the pellicle film 21 housed therein in a sealed state.

As has been described with reference to FIG. 4, the first inspection method according to the third embodiment includes the first measurement step.

This makes the first inspection method according to the third embodiment capable of easily inspecting the pellicle film 21 housed in the pellicle case 10C in a sealed state.

As has been described with reference to FIG. 4, the second inspection method according to the third embodiment includes the second measurement step.

This makes the second inspection method according to the third embodiment capable of easily inspecting the pellicle film 21 housed in the pellicle case 10C in a sealed state.

### Reference Signs List

The disclosure of Japanese Patent Application No. 2023-218337 filed on Dec. 25, 2023 is incorporated herein by reference in their entirety.

All publications, patent applications, and technical standards mentioned in the present specification are incorporated herein by reference to the same extent as if each individual publication, patent application, or technical standard was specifically and individually indicated to be incorporated by reference.

## Claims

1. A pellicle case for housing a pellicle comprising a pellicle film in a sealed state,
the pellicle case comprising a body and a lid,
wherein the body has a first planar window for inspecting the pellicle film,
wherein the lid has a second planar window for inspecting the pellicle film, which is disposed opposite to the first planar window, and
wherein the pellicle case satisfies at least one of the following requirement (a) or (b):
(a) a light shielding layer is formed on at least a portion of an outer surface of one of the first planar window or the second planar window,
wherein a planar window, among the first planar window and the second planar window, on a side on which the light shielding layer is not formed has a transmittance for light having a wavelength of from 0.4 µm to 0.7 µm of 75% or more, and
wherein the light shielding layer has a reflectance for light having a wavelength of from 0.4 µm to 0.6 µm of 5% or less; or
(b) each of the first planar window and the second planar window has a transmittance for light having a wavelength of from 2 µm to 10 µm of 70% or more.

2. The pellicle case according to claim 1,
wherein the pellicle case satisfies the requirement (a), and
wherein the light shielding layer is formed on an entire outer surface of one of the first planar window or the second planar window.

3. The pellicle case according to claim 1, wherein the pellicle case satisfies the requirement (b).

4. The pellicle case according to claim 1,
wherein the pellicle case satisfies the requirement (a), and
wherein the light shielding layer is formed on a portion of the outer surface of one of the first planar window or the second planar window.

5. The pellicle case according to claim 4, wherein the pellicle case further satisfies the requirement (b).

6. The pellicle case according to claim 1,
wherein at least one of the body or the lid has:
a vent passage that communicates an interior and an exterior of the pellicle case;
a valve capable of opening and closing the vent passage; and
a filter disposed in the vent passage,
wherein the filter is located at a position closer to an interior side of the pellicle case than the valve.

7. A pellicle assembly comprising:
the pellicle case according to any one of claims 1 to 6; and
a pellicle housed in the pellicle case in a sealed state,
wherein the pellicle comprises a pellicle film, and
wherein the first planar window is disposed opposite to the second planar window with the pellicle film interposed therebetween.

8. A method of inspecting the pellicle housed in the pellicle assembly according to claim 7 in a sealed state,
wherein the pellicle case satisfies the requirement (a), and
wherein the pellicle film comprises a plurality of carbon nanotubes,
the method comprising irradiating excitation light to the pellicle film through another one of the first planar window or the second planar window, to measure a ratio of an intensity of G band to an intensity of D band, by Raman spectroscopy.

9. A method of inspecting the pellicle housed in the pellicle assembly according to claim 7 in a vacuum sealed state,
wherein the pellicle case satisfies the requirement (b),
the method comprising irradiating continuous light to the pellicle film through one of the first planar window or the second planar window, to measure an emissivity by Fourier-transform infrared spectroscopy.
